(19) Europäisches Patentamt European Patent Office Office européen des brevets

(11) **EP 3 180 668 B1**

(12) **EUROPEAN PATENT SPECIFICATION**

(45) Date of publication and mention
of the grant of the patent:
**08.07.2020 Bulletin 2020/28**

(51) Int Cl.:
**G05D 1/08** *(2006.01)*          **G06F 30/20** *(2020.01)*
**B63B 71/00** *(2020.01)*

(21) Application number: **14756001.5**

(22) Date of filing: **15.08.2014**

(86) International application number:
**PCT/EP2014/067460**

(87) International publication number:
**WO 2016/023592 (18.02.2016 Gazette 2016/07)**

(54) **RIGHTING ARM MODEL DETERMINATION**

BESTIMMUNG EINES AUFRICHTARMMODELLS

DÉTERMINATION DE MODÈLE DE BRAS DE LEVIER DE REDRESSEMENT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**21.06.2017 Bulletin 2017/25**

(73) Proprietor: **ABB Schweiz AG**
**5400 Baden (CH)**

(72) Inventors:
• **LINDER, Jonas**
  **S-582 34 Linköping (SE)**
• **ENQVIST, Martin**
  **S-583 36 Linköping (SE)**
• **GUSTAFSSON, Fredrik**
  **S-586 63 Linköping (SE)**
• **SJÖBERG, Johan**
  **S-722 19 Västerås (SE)**

(74) Representative: **Kransell & Wennborg KB**
**P.O. Box 27834**
**115 93 Stockholm (SE)**

(56) References cited:
**WO-A1-2013/172408      US-B1- 6 367 400**

• **R. A. IBRAHIM ET AL: "Modeling of Ship Roll
Dynamics and Its Coupling with Heave and
Pitch", MATHEMATICAL PROBLEMS IN
ENGINEERING, ARTICLE ID 723402, vol. 30, no.
5, 1 January 2010 (2010-01-01), pages 741-32,
XP055185198, ISSN: 1024-123X, DOI:
10.1115/1.2777172**

**Description**

FIELD OF THE INVENTION

The present invention relates to a method, ship stability determining arrangement and computer program product for determining a righting arm model of a ship.

BACKGROUND

Ships have been around for a long time for transportation of goods and people. As they may be very large, they are in many cases still the most economical way to transport goods over long distances.

One important factor when operating a ship is the stability. It may for instance be important that the ship is able to withstand harsh weather conditions without capsizing, such as strong winds and high waves.

One property that is commonly used when determining the stability of a ship is the righting arm, which when the ship motion is small has a direct connection to the metacentric height.

Since the righting arm is so important for the stability of the ship, there are many ways in which a model of it may be estimated. Normally, the righting arm is first computed during the design of a ship but is then often determined by an inclining test once the ship has been built. The inclining test can also be performed when a ship or offshore floating platform is in service. The test basically means that a certain amount of weight is moved from one side of the ship to the other side and the change in angle is measured. Based on this data, a model of the righting arm, which has a dependence on the angle, can be computed. Preferably the test is done inshore in calm weather and in still water.

For small angles, the righting arm is directly related to the metacentric height, which in itself is directly related to the ship's rolling period. Therefore, an estimate of the metacentric height can be established by measuring the eigenperiod of the ship roll, also known as the natural period. Ships in waves will be forced to roll with the period of the waves and not the eigenperiod. Hence, this kind of estimation should also be conducted in calm weather similar to the inclining test.

In "Modeling of Ship Roll Dynamics and Its Coupling with Heave and Pitch", by R. A. Ibrahim and I. M. Grace, Mathematical Problems in Engineering; Volume 30, No. 5, 2010, the dynamic behavior of ships navigating in severe environmental conditions is studied through developing their governing equations of motion taking into account the inherent nonlinearity of large-amplitude ship motion. The paper presents the coupled nonlinear equations of motion in heave, roll, and pitch based on physical grounds. The ingredients of the formulation are comprised of three main components. These are the inertia forces and moments, restoring forces and moments, and damping forces and moments with an emphasis to the roll damping moment. In the formulation of the restoring forces and moments, the influence of large-amplitude ship motions will be considered together with ocean wave loads. The special cases of coupled roll-pitch and purely roll equations of motion are obtained from the general formulation. The paper also includes an assessment of roll stochastic stability and probabilistic approaches used to estimate the probability of capsizing and parameter identification.

There are also a number of patents in the area, but they all assume that the righting arm model or more specifically the metacentric height can be estimated from the natural roll. In for instance US 2431405, a natural roll movement is started by pendulums. Angles are then measured by pendulums or inclinometers. In US 3982424 electrical gyros are used to measure the rotation instead in order to achieve higher sensitivity. In the document, it is stated that usage of smaller excitations coming from wind gusts etc is enabled. However, the roll motion must still mainly consist of the natural roll motion. In WO 2005/101953, modern inclinometers are used to measure the roll angle and some kind of Fourier transform algorithm is then used to sort different components to achieve a more stable estimate.

Another document describing determination of metacentric height is WO 2013/172408, where the estimation is performed using an acceleration sensor and an angle speed sensor.

As can be seen the righting arm model is determined during calm conditions. However, it would be of interest to be able to determine a model of the righting arm also when the weather is not calm, especially since that is a situation when stability is most important. Furthermore these situations normally occur at sea, which means that the only information that can be used in the estimation has to be available on the ship itself, for instance via ship sensors.

The present invention is directed towards solving this problem, namely the problem of providing a way to determine a model of the righting arm that may be used also when the environment is not calm, but instead has a significant influence on the ship motion.

There is therefore a need for improvement on this situation.

SUMMARY OF THE INVENTION

The present invention addresses this situation. The invention therefore aims at solving the problem of providing an improvement in relation to determining ship stability.

This object is according to a first aspect of the invention solved through a method of determining a model of the righting arm of a ship, the method being performed by a ship stability determining arrangement and comprising the steps of:

- obtaining a ship excitation signal applied in the control of the ship,
- obtaining ship motion data from ship sensors when the ship is under influence of the ship excitation signal,
- using the ship motion data and the excitation signal in a dynamic model of the ship comprising a process disturbance and a parameter set comprising at least one parameter defining a righting arm model,
- determining one or more residuals, and
- obtaining the righting arm model through minimizing a function of the residuals.

This object is according to a second aspect of the invention solved through a ship stability determining arrangement for determining a model of the righting arm of a ship, the arrangement comprising a righting arm model determining unit configured to:

- obtain a ship excitation signal applied in the control of the ship,
- obtain ship motion data from ship sensors when the ship is under influence of the ship excitation signal,
- use the ship motion data and the excitation signal in a dynamic model of the ship comprising a process disturbance and a parameter set comprising at least one parameter defining a righting arm model,
- determine one or more residuals, and
- obtain the righting arm model through minimizing a function of the residuals.

This object is according to a third aspect of the invention achieved through a computer program product for determining a model of the righting arm of a ship, the computer program product being provided on a data carrier comprising computer program code configured to cause a righting arm model determining unit of a ship stability determining arrangement to, when the computer program code is loaded into the righting arm model determining unit

- obtain a ship excitation signal applied in the control of the ship,
- obtain ship motion data from ship sensors when the ship is under influence of the ship excitation signal,
- use the ship motion data and the excitation signal in a dynamic model of the ship comprising a process disturbance and a parameter set comprising at least one parameter defining a righting arm model,
- determine one or more residuals, and
- obtain the righting arm model through minimizing a function of the residuals.

The present invention has a number of advantages. The effects of disturbances in the environment as well as in the ship itself are reduced in the estimation of the righting arm model. Thereby a good estimation of the righting arm model is provided that may be used also when the environment is not calm, for instance, when there are strong winds or significant waves. The righting arm model may thus be determined at those instances when the stability is most important. Furthermore, when knowing the ship stability properties it is possible to use this information to perform a number of suitable stabilising measures. The righting arm model is furthermore obtained with a limited number of onboard sensor signals.

BRIEF DESCRIPTION OF THE DRAWINGS

The present invention will in the following be described with reference being made to the accompanying drawings, where

Fig. 1 schematically shows a ship,
Fig. 2 schematically shows a computerized control system controlling various operations of the ship and including a ship stability determining arrangement,
Fig. 3 schematically shows a sketch of a ship with a number of points that are relevant for stability,
Fig. 4 shows a flow chart of a number of method steps performed in a method of determining a righting arm model of the ship,
Fig. 5 shows an example of a ship model used to determine the righting arm model at small angles,
Fig. 6 schematically shows the ship model when the ship is equipped with an inertial measurement unit, and
Fig. 7 schematically shows a data carrier with computer program code, in the form of a CD-ROM disc, for performing the steps of the method.

DETAILED DESCRIPTION OF THE INVENTION

In the following, a detailed description of preferred embodiments of a method, ship stability determining arrangement and computer program product for determining a righting arm model of a ship will be given.

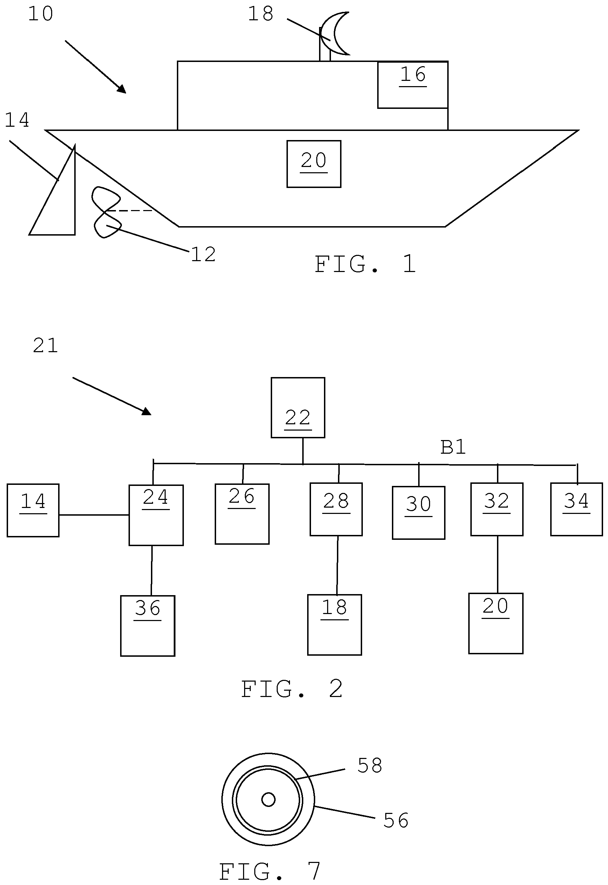

Fig. 1 schematically shows a ship 10. The ship 10, shown in fig. 1, comprises a rudder 14, a propeller 12 as well as a radar 18. A rudder is one type of actuator that may be used on the ship. It should here be realized that it is possible to use also other actuators. The ship 10 also comprises an Inertial Measurement Unit (IMU) 20 configured to measure ship motion data such as angular velocity and acceleration of the ship. For this reason the IMU 20 may comprise an accelerometer and a gyro. The propeller 12 is also connected to an engine (not shown) in order to propel the ship forward or backward. In order to control the propeller 12 and engine as well as the rudder 14, the ship 10 is also provided with a bridge 16, where various aspects of the ship 10 can be controlled. The rudder 14, propeller 12, engine, radar 18 and IMU 20 are examples of entities used in relation to the navigation or steering of the ship 10. In the figure only one propeller is shown. It should be realized that there may be more propellers, for instance in the bow. On the ship there may furthermore be ballast tanks (not shown), which may contain liquid such as water in order to influence the steering of the vessel.

Fig. 2 shows a block schematic of a simplified control system 21 for controlling the ship. The control system 21 is a computerized control system.

In fig. 2 there is a righting arm model determining unit 22. In this embodiment it is implemented in a separate computer that determines a righting arm model of the ship. However, this is only one example of a realization of the righting arm model determining unit. It should be understood that it may just as well be provided as a part of another computer in the system 21.

The righting arm model determining unit 22 is furthermore a part of a ship stability determining arrangement, which as an example may only comprise the righting arm model determining unit.

The righting arm model determining unit 22 is connected to a data bus B1.

There is furthermore a group of ship handling computers connected to the bus B1. The computers of the group are provided for handling various aspects of the ship, such as navigation and security aspects.

The group comprises a manoeuvring control computer 24, a forecasting computer 26, a tracking computer 28, a chart computer 30, a sensor handling computer 32 and an external indications computer 34. These computers are involved in handling various aspects of the ship. The manoeuvring control computer 24 may be involved in controlling manoeuvring such as steering using the rudder and controlling direction and speed through controlling the propeller. For this reason it is connected to the engine 36 and to the rudder 14. It may also control the ballast tanks in order to further influence the manoeuvrability. It may for this reason be connected to valves of the tanks in order to control filling and emptying. The forecasting computer 26 is a computer used for keeping track of the weather and receiving weather forecast data from weather forecast services. The data may comprise weather forecasts such as forecasts of low pressure areas, their movements and their wind speeds. The tracking computer 28 is used for tracking other vessels and is therefore connected to the radar 18. This computer 28, which may be part of an Automatic Identification (AIS) system, is used for keeping track of mobile objects in the environment. The chart computer 30 comprises navigation charts of the waters through which the ship is to move. The chart computer 30 keeps track of stationary objects or obstacles in the environment. The chart computer 30 may also comprise route data, i.e. data defining a route that the ship is to take.

The sensor handling computer 32 is provided to receive sensor data such as position data like GPS position data, speed data and depth data of the ship. More importantly it is also connected to the IMU 20 to collect the angular velocity and acceleration data.

Finally, the external indications computer 34 is provided for receiving external indications such as piracy indications and/or International Ship and Port Facility Security (ISPS) indications.

In some variations there may also be a load computer, which keeps track of the load distribution and cargo mass.

The ship stability determining arrangement may in addition to the righting arm model determining unit 22 comprise one or more of the manoeuvring control computer 24, sensor handling computer 32, load computer as well as sensors such as IMU 20, GPS sensor etc. and other elements such as rudder, ballast tank valve, etc.

There may also be a control computer involved in ship management, such as controlling ventilation and lights.

As mentioned initially, knowledge of the stability of the ship is vital for safe operation. The stability is often determined based on the righting arm model, which in some cases is proportional to the metacentric height.

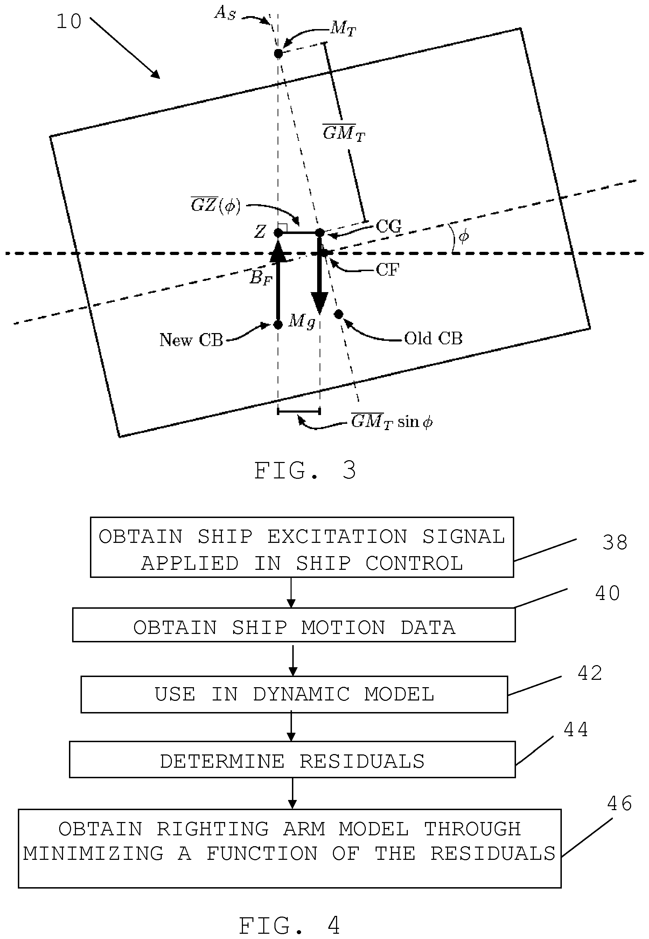

In order to understand what the righting arm is in relation to one type of ship motion, here roll, reference is now being made to fig. 3, which shows a sketch of a ship with a number of points that are relevant for stability. The ship 10 has, as all mechanical objects, a centre of Gravity CG, which is typically in the centre of the ship 10. A vertical ship axis $A_S$ runs vertically through the ship hull, i.e. from the superstructure through the centre of gravity CG, through a centre of flotation CF towards the keel. The centre of flotation CF is the point where the line $A_S$ intersects the waterline at rest. On the same axis in a direction away from both the centre of gravity CG and centre of flotation CF, the ship has a centre of buoyancy CB, which is denoted an old centre of buoyancy CB applicable when the ship vertical axis is also vertical in relation to earth. The ship vertical axis $A_S$ thus coincides with the direction of gravity at rest.

The roll angle $\phi$ may here be determined as the angle between a line perpendicular to the ship vertical axis $A_S$ and the plane of the waterline at the centre of flotation CF, which defines a pivot point around which the ship rolls. As can be seen in fig. 3, this angle is also the angle between the ship vertical axis $A_S$ and the vertical line through a new centre of buoyancy CB. The rolling motion will result in the centre of buoyancy CB being shifted from the ship vertical axis. This shift from the old to the new centre of buoyancy creates a restoring torque. The restoring torque can hence be defined as

$$\rho g \nabla \overline{GZ}(\phi) \qquad\qquad (1)$$

where $\nabla$ is the displaced water volume, g is the acceleration of gravity and $\rho$ the density of water.

Furthermore, $\overline{GZ}(\phi)$ is the righting arm, which is a function dependent on the roll angle, which is the distance between the centre of gravity CG and the above-mentioned vertical line through the new centre of buoyancy.

It can be shown that for small roll angles $\phi$, the righting arm can be described using the metacentre $M_T$. The metacentre $M_T$ is the point at which a vertical line through the new heeled centre of buoyancy CB crosses the line $A_S$. The distance between the centre of gravity CG and the metacentre $M_T$ is called the metacentric height $\overline{GM_T}$. The shift of the centre of buoyancy CB will thus for small angles result in the restoring torque

$$\rho g \nabla \overline{GM}_T \sin(\phi) \qquad\qquad (2)$$

where, again $\nabla$ is the displaced water volume, g is the acceleration of gravity and $\rho$ the density of water.

Therefore the righting arm, which at times is related to the metacentric height, is an important measure of the stability of the ship.

The metacentre $M_T$ is in fig. 3 shown as being provided on the other side of the centre of gravity CG in relation to the old centre of buoyancy CB. However, note that the position of the metacentre $M_T$, and thus the metacentric height $\overline{GM_T}$ may vary along the vertical ship axis $A_S$ depending on a number of factors, such as hull shape and loading conditions. In the same way, the shape of the righting arm function $\overline{GZ}(\phi)$ may vary depending on similar factors.

Traditionally, a model of the righting arm has been determined based on some kind of excitation and recording of the ship's response assuming that there is low influence from environmental forces such as waves and winds, i.e. the error from neglecting these terms are assumed to be insignificant to the estimation. However, this assumption, i.e. that there are no waves, is very limiting and methods neglecting these effects will fail if there are significant environmental forces acting on the ship.

If there are waves, there will be a contribution from these waves in the righting arm estimate. It would be of interest to remove this influence from the determination so that a better estimate of the righting arm model is obtained that is reliable also when the environment is not calm.

A general way in which the righting arm model may be determined without contributions from the environmental or external disturbances will now be described with reference being made to fig. 4. Fig. 4 shows a flow chart of a number of method steps in a method for determining a righting arm model. The method is performed in the righting arm model determining unit 22.

In order to determine the righting arm model, the righting arm model determining unit 22 obtains a ship excitation signal $r$ applied in the control of the ship, step 38. This may be a signal able to excite the ship at least with regard to the pivoting motion being investigated, here the roll. In this example it is a rudder signal $r$ applied to the rudder 14. The signal $r$ may as an example be obtained from the manoeuvring control computer 24. If the rudder is provided with a sensor, it may also be obtained from the sensor handling computer 32 or directly from this sensor.

The righting arm model determining unit 22 also obtains ship motion data, step 40. The ship motion data may comprise a speed signal in the form of the angular velocity around the pivot point CF and an acceleration signal in the form of an acceleration detected by the IMU 20. This data may furthermore be obtained when the ship is under the influence of the ship excitation signal $r$.

The righting arm model determining unit 22 then uses the ship motion data and the excitation signal $r$ in a dynamic model of the ship, step 42.

The dynamic model that models the ship has one or more output signals $y$. A dynamic model may as an example be set up as a state-space model, where there is a measurement model $h$ relating the output $y$ to the states and a function that describes the system dynamics, here called a state transition function $f$, where both $h$ and $f$ employ a parameter set, with ship parameters. The parameter set may as an example be provided in the form of a parameter vector $\theta$. The state-space model may be a non-linear state space model. Here the righting arm model is assumed to be parameterized with some of the parameters in $\theta$. If the angles $\phi$ are small, the righting arm model may be parameterized using the metacentric height $\overline{GM}_T$ as a parameter.

The dynamic model may for instance be the following state-space model

$$\dot{x}(t) = f\big(x(t), r(t), v(t), \theta\big) \qquad (3)$$

$$y(t) = h\big(x(t), r(t), e(t), \theta\big) \qquad (4)$$

where $x(t)$ is the current state, $\dot{x}(t)$ is the derivative of the current state, $r(t)$ is the excitation signal, $v(t)$ is a process disturbance, for instance, an environmental disturbance, such as waves, or vibrations from the engine, and $e(t)$ is a measurement error, which in some situations may be omitted. The righting arm model parameters are a subset of the parameters in the parameter vector $\theta$. It can be seen that the non-linear function $h$ is a function of at least one state, the excitation signal and the variable set. It can also be seen that the non-linear function $f$ is a function of at least one state, the excitation signal, the parameter set and the process disturbance. It should here be realized that it is possible with more states than one. It should also be realized that it is possible to omit the measurement error. The excitation signal $r(t)$ may also be considered to be an input signal to the dynamic model.

The righting arm model determining unit 22 then determines one or more residuals $\varepsilon(t|\theta)$ using the measurements, the state transition function, excitation signal and parameter set, step 44.

The residuals may be determined for a particular parameter vector $\theta$ according to:

$$\varepsilon(t|\theta) = y(t) - \hat{y}(t|\theta) \qquad (5)$$

It can thus be seen that a residual is obtained as a difference between a measured signal $y(t)$ and a corresponding estimate $\hat{y}(t|\theta)$ of the measured signal in the chosen dynamic model.

The righting arm model is then obtained through minimizing a function of the residuals, step 46. In some cases there may be a requirement that the residuals are uncorrelated with the excitation signal.

If a linear model is considered, the dynamic model may be represented by a transfer operator $G(p,\theta)$ for an input signal $u$ and an output signal $y$. Here $p$ is the differentiation operator. Note that the transfer operator $G(p,\theta)$ is dependent of the parameters of interest.

The residuals may then be determined based on knowledge of the correlation between the output $y$ and the input $u$ of the transfer function $G(p,\theta)$ and the excitation signal $r$. Here both $y$ and $u$ contain contributions from the process disturbance and the excitation signal.

One example will now be given of how the righting arm model determining unit 22 determines the righting arm model for small angles $\phi$ where the influences from the process disturbance are limited. The angles are considered to be small when they are below 15 degrees. However, for improved accuracy in the determination it is advantageous if the angles are below 10 degrees.

When the angles are small the righting arm model can be considered to be

$$\overline{GZ}(\phi) = \overline{GM}_T \phi \qquad (6)$$

The righting arm model can thus in the case of small angles be considered to be the metacentric height $\overline{GM}_T$ times the angle $\phi$. This means that in this case it may be sufficient to determine the metacentric height $\overline{GM}_T$ in order to obtain a stability measure.

Put differently, the model of the righting arm describes the righting arm as a function of a pivoting angle. In the case of small angles, the righting arm is proportional to the metacentric height.

In order to parameterize the estimate $\hat{y}$ of the measured signal $y$ it is possible to employ a dynamical model of the ship, for instance a mechanical mass-spring-damper model.

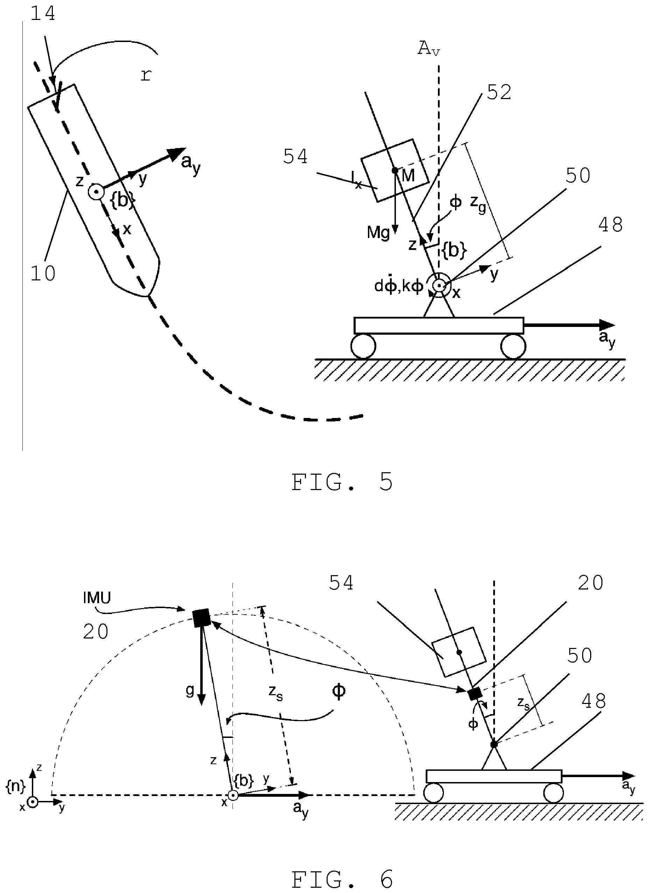

One such model is schematically indicated in fig. 5. In the left part of fig. 5, the ship 10 is shown with the rudder 14 being actuated by the ship excitation signal $r$, thus in this example it is a rudder signal or steering reference. Due to the rudder angle, the ship 10 is also shown as making a turn resulting in the unknown acceleration $a_y$. This external force is more particularly acting on the centre of rotation, i.e. on the centre of flotation CF. As can be seen in the left hand side of fig. 5, this situation can be modelled, as shown on the right hand side of fig. 5, as an inverted pendulum 52 on a cart 48, where the pendulum 52 swings around a pivot point 50 corresponding to the centre of flotation CF, which pivot point 50 is provided on a vertical axis $A_V$ of the cart. On this pendulum 52 there is placed a first body 54 with mass $M$ and inertia $I_x$ at a distance $z_g$ from the axis 50 along the pendulum 52 corresponding to the ship. There is furthermore a spring constant $k$. The spring constant $k$ represents the physical restoring properties of the ship and is dependent on factors such as the hull shape etc.

The pendulum is also shown as having a swinging angle $\phi$ corresponding to the roll angle and a linear damping coefficient $d$ around the pivot point 50. As mentioned, the pendulum 52 is disturbed by an external force which results in the unknown acceleration $a_y$. There are two torsional torques acting on the pendulum, one linearly dependent on the angle $\phi$ corresponding to the hydrostatic restoring forces, and one linearly dependent on the angular velocity $\dot{\phi}$ corresponding to damping due to hydrodynamic effects. Finally, there is a process disturbance torque $v$ acting on the axis 50.

The model of the ship may then be described by the differential equation:

$$\ddot{\phi} = -\frac{k - Mgz_g}{I}\phi - \frac{d}{I}\dot{\phi} + \frac{Mz_g}{I}a_y + \frac{1}{I}v \qquad (7)$$

where $I = I_x + Mz_g^2$ and, as mentioned, it is assumed that $\phi$ is small.

Equation (7) thus sets up a differential equation that is related to an angle $\phi$ around a pivoting point corresponding to the centre of roll. The angle is therefore also a roll angle. In equation (7), the first term is a restoring torque proportional to $\phi$, the second term is a damping term, the third term is an excitation dependent disturbance term, i.e. a term describing the disturbance caused by one or more excitations of the ship, and the fourth term is a process disturbance term i.e. a term describing the disturbance caused by for instance, vibrations from the engine or the environment, such as the waves.

The model thus comprises a number of parameters $d$, $I_x$, $k$, $M$, $z_g$ of which at least some are unknown and then especially the spring coefficient $k$.

As the angles are small and the restoring torque is the same as the one previously described, the following relationship may be obtained: $pg\,\overline{VGM_T} = k - Mgz_g$.

$$\overline{GM_T} = \frac{k - Mgz_g}{Mg}$$

Furthermore as V is the displaced water volume, it can be seen that $\rho V = M$. Thereby may be obtained.

Here $k$ can be understood to describe geometric properties of the metacentric height while $M$ and $z_g$ describe the dependence on mass and its location.

As mentioned earlier, the IMU 20 of the ship is provided with a gyro and accelerometer. The position of the IMU in the model is schematically shown in fig. 6.

As can be seen the IMU 20 is placed a distance $z_s$ from the pivot point 50 along the pendulum 52, which in this example is between the first body 54 and the pivot point 50.

The righting arm model determining unit 22 again obtains the ship excitation signal $r$, which is a signal able to excite the ship at least with regard to the roll motion. Once again, it is the rudder signal $r$ applied to the rudder 14. The righting arm model determining unit 22 also obtains ship motion data, in the form of an angular velocity $y_1$ around the pivot point, and the acceleration signal, in the form of a detected acceleration $y_2$.

The righting arm model determining unit 22 then uses the ship motion data in the dynamic model.

Furthermore, the ship movement data is relative to the movement of the ship in relation to the ship vertical axis or more particularly the movement in relation to the pivot point on this axis.

As described above the metacentric height may be directly obtained via the second term, the restoring torque in equation (7). However, in order to do this, the effects of the fourth term have to be mitigated. Furthermore, also the third term may have to be handled as it is based on the unknown acceleration $a_y$.

The acceleration $y_2$ measured by the IMU may be related to $a_y$ in a known way, e.g. tangential. For instance, the relationship could be described in the following way:

$$y_2 = a_s + e_2 = -z_s\ddot{\phi} + g\phi + a_y \qquad (8)$$

where $z_s$ is the distance from the pivot point to the IMU coordinate system and $g$ is again gravity.

The relationship in equation (8) can be used to express the unknown acceleration $a_y$ in terms of the measured signal $y_2$ and the states $\phi$ and $\dot{\phi}$. In this case it is also possible to eliminate $a_y$ through solving equation (8) for $a_y$ and inserting it in equation (7).

However, after this has been done, the process disturbance is still present. This disturbance thus has to be handled in order to be able to determine the metacentric height $\overline{GM}_T$.

The metacentric height determining unit 22, uses the measurements, the dynamic model and excitation signal $r$ to separate the induced motion due to the process disturbance from the motion due to the ship excitation signal $r$. Thereby the influence of the process disturbance term is separated from the parameters of the model. This is again based on residuals. This may be done through employing a correlation that exists between the ship excitation signal $r$ and at least one of the measured signals.

Equation(7) may here also be converted into a transfer operator $G(p,\theta)$ for an input $u$ and an output $y$. The separation may then involve using this transfer operator $G(p,\theta)$. The dynamical model may also be in discrete time. For instance, Tustin's method has been used for the time discretization of a continuous time model.

The influence of the process disturbance term may more particularly be separated through applying statistical variation functionality on an expression defining the relationship between the input signal $u$, output signal $y$, transfer operator $G(p,\theta)$ and process disturbance $v$ for determining the transfer operator $G(p,\theta)$. The applying of statistical variation functionality may involve determining the expectation.

To get an idea of how the effect of process disturbances can be eliminated using the above-mentioned correlation the discrete-time linear system below may be considered

$$y = G_d(q)u + v \qquad\qquad (9)$$

where $q$ is the shift-operator, $v$ is the process disturbance (waves, other weather effects and other disturbances such as vibrations from the engine), $y$ is a measured signal and $u$ is another measured signal given by a relationship of the form

$$u = K_1(q)r + K_2(q)y \qquad\qquad (10)$$

The goal is to estimate $G_d(q)$ and the signal that can be manipulated is $r$, i.e. the excitation signal. It may also be assumed that $K_i$ are unknown. If first both sides of equation (9) are multiplied by the excitation signal followed by taking the expectation, the result is:

$$E[yr] = G_d(q)E[ur] + E[vr] \Leftrightarrow \Phi_{yr} = G_d(q)\Phi_{ur} + 0$$

where $E[vr]=0$ because $v$ and $r$ are uncorrelated.. It can be seen that the transfer function now is a quotient between two spectra as

$$G_d(q) = \frac{\Phi_{yr}}{\Phi_{ur}}$$

and the effect from the process disturbance signal is eliminated as desired. By matching $G_d(q)$ with a time discretized version of the dynamical model it is then possible to determine at least one of the parameters in the dynamical model, i.e. the parameters in equation (7), since the coefficients of $G_d(q)$ are mapped to the parameters in equation (7).

The approach above should mostly be seen as a motivation of how non-correlation between the process disturbance $v$ and the excitation signal $r$ can be used to mitigate the effect of the process disturbance on the estimated model.

A practical approach to the parameter identification is the extended instrumental variable method.

An instrumental variable method employs a number of instruments $\xi_t$ that are uncorrelated with the process disturbance $v_t$, measurement noise $e_{1,t}$ and $e_{2,t}$.

This may be achieved through solving

$$\widehat{\theta} = \arg\min \left\| \Phi_N \theta - Y_N \right\|_2^2 \qquad\qquad (13)$$

where

$$\Phi_N = \begin{bmatrix} \xi_1 & . & . & . & \xi_N \end{bmatrix} \begin{bmatrix} \varphi_1^T \\ . \\ . \\ . \\ \varphi_N^T \end{bmatrix}, \quad Y_N = \begin{bmatrix} \xi_1 & . & . & . & \xi_N \end{bmatrix} \begin{bmatrix} y_1 \\ . \\ . \\ . \\ y_N \end{bmatrix}$$

and where $\theta$ is the parameter vector of the transfer operator and the regression vector is $\varphi_t^T = \begin{bmatrix} -y_{t-1}, -y_{t-2}, u_t - u_{t-2} \end{bmatrix}$.
The orders of $y_t$ and $u_t$ in the regression vector is derived from the time discretized version of the mechanical mass-spring-damper model in equation (7).

Iteration is then employed.

After each iteration, a new estimate $\hat{\theta}$ of the parameter vector may be used to simulate $y$ and $u$ from the rudder angle $r$. The instruments may be chosen in the form

$$\xi_t = \begin{bmatrix} r_t & . & . & . & r_{t-n_r} & y_{s,t} & . & . & . & y_{s,t-n_y} & u_{s,t} & . & . & . & u_{s,t-n_u} \end{bmatrix}^T$$

where $r_t$ is the rudder angle at time $t$, $y_{s,t}$ and $u_{s,t}$ are the output and the input, respectively, simulated at time $t$ using equation (7), the relationship between measured acceleration $y_2$ and the acceleration $a_y$ as well as the estimate from the previous iteration.

The rudder angle $r$ and the simulated signals $y_s$ and $u_s$ might then be used as instruments in the next iteration. The iteration is aborted if $\|\hat{\theta}_i - \hat{\theta}_{i-1}\|_2$ is below a threshold or after a maximum number of iterations.

It can thus be seen that the instrumental variable method separates the influence of the process disturbance term through applying statistical variation functionality $\hat{\theta} = \arg\min \|\Phi_N \theta - Y_N\|_2^2$ on an expression defining the relationship between the input signal $u$, the output signal $y$ and using the correlation between these signals and the rudder signal $r$.

It can be seen that the righting arm model is in all the above given examples determined in a way so that the influence of the process disturbance on the righting arm model are mitigated. Furthermore, the determination may be carried out only using ship sensor signals. This means that the righting arm model may be determined on an isolated ship far out at sea during non-calm weather conditions.

Once the righting arm model is known it may be used for a number of interesting purposes. It may be used for detecting changes in stability due to free surface movement, which can be caused by flooding or ballast exchange at sea. It could also be used as an alarm for stability loss. Furthermore, if the ship is found to have lost stability it may be possible to control the ship for counteracting this effect. This control is with advantage performed using a ship excitation such as the rudder signal. The excitation signal, for instance in the form of the rudder angle, may then be used to reduce roll motion.

A righting arm model has above been described in relation to roll. It should however be realized that the righting arm model may be determined in the same manner for pitch.

It is clear that the invention is in no way limited to the mass-spring-damper model of the ship as a pendulum on a cart. It is possible to use other dynamic ship models. It is in fact clear that it is possible to implement the inventive concept without employing a dynamic model of the ship.

Furthermore, the determination of a righting arm model is not limited to being made on a ship. All or parts of the functionality of the righting arm model determining unit may be provided in a computer with which the ship communicates, for instance a computer on land. In this case the ship may send relevant data to this computer on land, which returns a computed righting arm model to the ship.

As was stated earlier the IMU is just one example of an entity that provides signals to be used. It is as an example possible to also or instead use an inclinometer, the radar and the GPS for providing suitable signals.

The ship stability determining arrangement may be implemented using software. It may thus be implemented using computer program code, which may be provided on one or more data carriers which performs the functionality of the ship stability determining arrangement when the program code thereon is being loaded into a computer, either on land or on the ship. One such data carrier 56 with computer program code 58, in the form of a CD ROM disc, is schematically shown in fig. 7. Such computer program may as an alternative be provided on another server and downloaded therefrom into the computer.

**Claims**

1.  A method of determining a model of the righting arm of a ship (10), the method being performed by a ship stability determining arrangement (22) and comprising the steps of:

    - obtaining (38) a ship excitation signal, $r$, applied in the control of the ship,
    - obtaining (40) ship motion data from ship sensors when the ship is under influence of the ship excitation signal,
    - using (42) the ship motion data and the excitation signal in a dynamic model of the ship comprising a process disturbance, $v$, and a parameter set, $\theta$, comprising at least one parameter defining a righting arm model,
    - determining (44) one or more residuals, and
    - obtaining (46) the righting arm model through minimizing a function of the residuals.

2.  The method according to claim 1, wherein the dynamic model may be expressed as a dynamic state space model comprising a measurement model, $h$, and a state transition function, $f$.

3.  The method according to claim 2, wherein the measurement model, $h$, is a function of at least one state, the excitation signal, the parameter set and the process disturbance and the state transition function, $f$, is a function of at least one state, the excitation signal and the parameter set.

4.  The method according to any previous claim, wherein the residuals are expressed as a difference between a measured signal and a corresponding estimate of the measured signal in the dynamic model.

5.  The method according to claim 2 or 3, wherein the dynamic model is linear and represented by a transfer operator, $G_d(q)$, and the residuals are obtained through multiplying the transfer operator, $G_d(q)$, as well as the process disturbance, $v$, with the excitation signal and taking the expectation.

6.  The method according to claim 2 or 3, wherein the dynamic model is linear and represented by a transfer operator, , where the residuals are obtained using an instrumental variable method on the transfer operator.

7.  The method according to any previous claim, wherein the parameter set is obtained from a spring-mass-damper model of the ship having a restoring torque, an excitation dependent disturbance term and a process disturbance term.

8.  The method according to claim 7, wherein the spring-mass-damper model is based on a differential equation related to a pivoting angle around a pivot point of the ship.

9.  The method according to claim 7 or 8, wherein the ship motion data comprises a speed signal, $y_1$, and an acceleration signal, $y_2$.

10. The method according to claim 9, wherein the ship acceleration, $a_y$, is eliminated from the spring-mass-damper model through solving an equation setting out the relationship between the acceleration signal and the ship acceleration, $a_y$, and inserting the expression for the ship acceleration in the spring-mass-damper model.

11. The method according to any previous claim, wherein the ship excitation signal, $r$, is a rudder signal.

12. The method according to any previous claim, wherein the righting arm model is proportional to to the metacentric height, $\overline{GM}_T$.

13. A ship stability determining arrangement for determining a model of the righting arm of a ship (10), the arrangement comprising a righting arm model determining unit (22) configured to:

    - obtain a ship excitation signal, $r$, applied in the control of the ship,
    - obtain ship motion data from ship sensors (20) when the ship is under influence of the ship excitation signal,
    - use the ship motion data and the excitation signal in a dynamic model of the ship comprising a process disturbance, $v$, and a parameter set, $\theta$, comprising at least one parameter defining the righting arm model,

**EP 3 180 668 B1**

- determine one or more residuals, and
- obtain the righting arm model through minimizing a function of the residuals.

14. The arrangement (22) according to claim 13, wherein the dynamic model may be expressed as a dynamic state space model comprising a measurement model, $h$, and a state transition function, $f$.

15. The arrangement (22) according to claim 14, wherein the measurement model, $h$, is a function of at least one state, the excitation signal, the parameter set and the process disturbance and the state transition function, $f$, is a function of at least one state, the excitation signal and the parameter set.

16. The arrangement (22) according to any of claims 13 - 15, wherein the residuals are expressed as a difference between a measured signal and a corresponding estimate of the measured signal in the dynamic model.

17. The arrangement (22) according to claim 14 or 15, wherein the dynamic model is linear and represented by a transfer operator, $G_d(q)$, and the process disturbance, $v$, and the righting arm model determining unit (22) is configured to obtain the residuals through multiplying the transfer operator , $G_d(q)$, as well as the process disturbance, $v$, with the excitation signal and taking the expectation.

18. The arrangement (22) according to claim 14 or 15, wherein the dynamic model is linear and represented by a transfer operator, , and the righting arm model determining unit (22) is configured to obtain the residuals using an instrumental variable method on the transfer operator.

19. The arrangement (22) according to any of claims 13 - 18, wherein the parameter set is obtained from a spring-mass-damper model of the ship having a restoring torque, an excitation dependent disturbance term and a process disturbance term.

20. The arrangement (20) according to claim 19, wherein the spring-mass-damper model is based on a differential equation related to a pivoting angle around a pivot point of the ship.

21. The arrangement (20) according to claim 13 - 20, further comprising a sensor handling computer (32) for receiving the ship speed data.

22. The arrangement according to claim 21, further comprising an inertial measurement unit (20) measuring ship speed data.

23. The arrangement (20) according to any of claims 13 - 22, further comprising a ship manoeuvring control computer (24).

24. A computer program product for determining a model of the righting arm of a ship, said computer program product being provided on a data carrier (56) comprising computer program code (58) configured to cause a righting arm model determining unit (22) of a ship stability determining arrangement to, when said computer program code is loaded into the righting arm model determining unit

- obtain a ship excitation signal, $r$, applied in the control of the ship,
- obtain ship motion data from ship sensors when the ship is under influence of the ship excitation signal,
- use the ship motion data and the excitation signal in a dynamic model of the ship comprising a process disturbance, $v$, and a parameter set, $\theta$, comprising at least one parameter defining the righting arm model,
- determine one or more residuals, and
- obtain the righting arm model through minimizing a function of the residuals.

**Patentansprüche**

1. Verfahren zum Ermitteln eines Modells des aufrichtenden Hebelarms eines Schiffs (10), wobei das Verfahren durch eine Schiffsstabilitätsermittlungsanordnung (22) ausgeführt wird und die folgenden Schritte umfasst:

- Erhalten (38) eines Schiffsanregungssignals, $r$, das bei der Steuerung des Schiffs angewandt wird,
- Erhalten (40) von Schiffsbewegungsdaten von Schiffssensoren, wenn das Schiff unter dem Einfluss des Schiffsanregungssignals steht,

- Verwenden (42) der Schiffsbewegungsdaten und des Anregungssignals in einem dynamischen Schiffsmodell, das eine Prozessstörung, $v$, und einen Parametersatz, $\theta$, umfasst, der mindestens einen Parameter umfasst, der ein Modell eines aufrichtenden Hebelarms definiert,
- Ermitteln (44) einer oder mehrerer Restgrößen, und
- Erhalten (46) des Modells eines aufrichtenden Hebelarms durch ein Minimieren einer Funktion der Restgrößen.

2. Verfahren nach Anspruch 1, wobei das dynamische Modell als ein dynamisches Zustandsraummodell ausgedrückt werden kann, das ein Messmodell, $h$, und eine Zustandsübergangsfunktion, $f$, umfasst.

3. Verfahren nach Anspruch 2, wobei das Messmodell, $h$, eine Funktion von mindestens einem Zustand, dem Anregungssignal, dem Parametersatz und der Prozessstörung ist und wobei die Zustandsübergangsfunktion, $f$, eine Funktion von mindestens einem Zustand, dem Anregungssignal und dem Parametersatz ist.

4. Verfahren nach einem der vorhergehenden Ansprüche, wobei die Restgrößen als eine Differenz zwischen einem gemessenen Signal und einer entsprechenden Schätzung des gemessenen Signals in dem dynamischen Modell ausgedrückt wird.

5. Verfahren nach Anspruch 2 oder 3, wobei das dynamische Modell linear ist und durch einen Transferoperator, $G_d(q)$, dargestellt wird, und wobei die Restgrößen durch ein Multiplizieren des Transferoperators, $G_d(q)$, sowie der Prozessstörung, $v$, mit dem Anregungssignal und durch ein Annehmen der Erwartung erhalten wird.

6. Verfahren nach Anspruch 2 oder 3, wobei das dynamische Modell linear ist und durch einen Transferoperator, dargestellt wird, wo die Restgrößen mithilfe eines Instrumentvariablenverfahrens an dem Transferoperator erhalten wird.

7. Verfahren nach einem der vorhergehenden Ansprüche, wobei der Parametersatz aus einem Feder-Masse-Dämpfer-Modell des Schiffs erhalten wird, das ein wiederherstellendes Drehmoment, einen anregungsabhängigen Störungsterm und einen Prozessstörungsterm aufweist.

8. Verfahren nach Anspruch 7, wobei das Feder-Masse-Dämpfer-Modell auf einer Differenzialgleichung beruht, die sich auf einen Schwenkwinkel um einen Schwenkpunkt des Schiffs bezieht.

9. Verfahren nach Anspruch 7 oder 8, wobei die Schiffsbewegungsdaten ein Geschwindigkeitssignal, $y_1$, und ein Beschleunigungssignal, $y_2$ umfassen.

10. Verfahren nach Anspruch 9, wobei die Schiffsbeschleunigung, $a_y$, aus dem Feder-Masse-Dämpfer-Modell entfernt wird durch ein Lösen einer Gleichung, welche die der Beziehung zwischen dem Beschleunigungssignal und der Schiffsbeschleunigung, $a_y$, darstellt, und durch ein Einfügen des Ausdrucks für die Schiffsbeschleunigung in das Feder-Masse-Dämpfer-Modell eliminiert.

11. Verfahren nach einem der vorhergehenden Ansprüche, wobei das Schiffsanregungssignal, $r$, ein Steuersignal ist.

12. Verfahren nach einem der vorhergehenden Ansprüche, wobei das Modell eines aufrichtenden Hebelarms proportional zur metazentrischen Höhe, $\overline{GM}_T$, ist.

13. Schiffsstabilitätsermittlungsanordnung zum Ermitteln eines Modells des aufrichtenden Hebelarms eines Schiffs (10), wobei die Anordnung eine Einheit zum Ermitteln eines Modells eines aufrichtenden Hebelarms (22) umfasst, die konfiguriert ist zum:

- Erhalten eines Schiffsanregungssignals, $r$, das bei der Steuerung des Schiffs angewandt wird,
- Erhalten von Schiffsbewegungsdaten von Schiffssensoren (20), wenn das Schiff unter dem Einfluss des Schiffsanregungssignals steht,
- Verwenden der Schiffsbewegungsdaten und des Anregungssignals in einem dynamischen Schiffsmodell, das eine Prozessstörung, $v$, und einen Parametersatz, $\theta$, umfasst, der mindestens einen Parameter umfasst, der das Modell eines aufrichtenden Hebelarms definiert,
- Ermitteln einer oder mehrerer Restgrößen, und
- Erhalten des Modells eines aufrichtenden Hebelarms durch ein Minimieren einer Funktion der Restgrößen.

**14.** Anordnung (22) nach Anspruch 13, wobei das dynamische Modell als ein dynamisches Zustandsraummodell ausgedrückt werden kann, das ein Messmodell, *h,* und eine Zustandsübergangsfunktion, *f,* umfasst.

**15.** Anordnung (22) nach Anspruch 14, wobei das Messmodell, *h,* eine Funktion von mindestens einem Zustand, dem Anregungssignal, dem Parametersatz und der Prozessstörung ist und wobei die Zustandsübergangsfunktion, *f,* eine Funktion von mindestens einem Zustand, dem Anregungssignal und dem Parametersatz ist.

**16.** Anordnung (22) nach einem der Ansprüche 13 bis 15, wobei die Restgrößen als eine Differenz zwischen einem gemessenen Signal und einer entsprechenden Schätzung des gemessenen Signals in dem dynamischen Modell ausgedrückt wird.

**17.** Anordnung (22) nach Anspruch 14 oder 15, wobei das dynamische Modell linear ist und durch einen Transferoperator, $G_d(q)$, und die Prozessstörung, *v,* dargestellt wird, und wobei die Einheit zum Ermitteln eines Modells eines aufrichtenden Hebelarms (22) konfiguriert ist zum Erhalten von Restgrößen durch ein Multiplizieren des Transferoperators, $G_d(q)$, sowie der Prozessstörung, *v,* mit dem Anregungssignal und durch ein Annehmen der Erwartung.

**18.** Anordnung (22) nach Anspruch 14 oder 15, wobei das dynamische Modell linear ist und durch einen Transferoperator, dargestellt wird, und wobei die Einheit zum Ermitteln eines Modells eines aufrichtenden Hebelarms (22) konfiguriert ist zum Erhalten der Restgrößen mithilfe eines Instrumentvariablenverfahrens an dem Transferoperator.

**19.** Anordnung (22) nach einem der Ansprüche 13 bis 18, wobei der Parametersatz aus einem Feder-Masse-Dämpfer-Modell des Schiffs erhalten wird, das ein wiederherstellendes Drehmoment, einen anregungsabhängigen Störungsterm und einen Prozessstörungsterm aufweist.

**20.** Anordnung (20) nach Anspruch 19, wobei das Feder-Masse-Dämpfer-Modell auf einer Differenzialgleichung beruht, die sich auf einen Schwenkwinkel um einen Schwenkpunkt des Schiffs bezieht.

**21.** Anordnung (20) einem der Ansprüche 13 bis 20, die außerdem einen Sensorbedienungscomputer (32) zum Empfangen der Schiffsgeschwindigkeitsdaten umfasst.

**22.** Anordnung nach Anspruch 21, die außerdem eine Trägheitsmesseinheit (20) zum Messen der Schiffsgeschwindigkeitsdaten umfasst.

**23.** Anordnung (20) nach einem der Ansprüche 13 bis 22, die außerdem einen Steuercomputer zur Schiffsmanövrierung (24) umfasst,

**24.** Computerprogrammprodukt zum Ermitteln eines Modells des aufrichtenden Hebelarms eines Schiffs, wobei das Computerprogrammprodukt auf einem Datenträger (56) bereitgestellt wird, der einen Computerprogrammcode (58) umfasst, der konfiguriert ist zum Veranlassen einer Einheit zum Ermitteln eines Modells eines aufrichtenden Hebelarms (22) einer Schiffsstabilitätsermittlungsanordnung, wenn der Computerprogrammcode in die Einheit zum Ermitteln eines Modells eines aufrichtenden Hebelarms geladen ist, zum:

- Erhalten eines Schiffsanregungssignals, *r,* das bei der Steuerung des Schiffs angewandt wird,
- Erhalten von Schiffsbewegungsdaten von Schiffssensoren, wenn das Schiff unter dem Einfluss des Schiffsanregungssignals steht,
- Verwenden der Schiffsbewegungsdaten und des Anregungssignals in einem dynamischen Schiffsmodell, das eine Prozessstörung, *v,* und einen Parametersatz, $\theta$, umfasst, der mindestens einen Parameter umfasst, der das Modell eines aufrichtenden Hebelarms definiert,
- Ermitteln einer oder mehrerer Restgrößen, und
- Erhalten des Modells eines aufrichtenden Hebelarms durch ein Minimieren einer Funktion der Restgrößen.

**Revendications**

**1.** Procédé de détermination d'un modèle du bras de levier de redressement d'un navire (10), le procédé étant réalisé par un dispositif (22) de détermination de stabilité de navire et comportant les étapes consistant à :

- obtenir (38) un signal d'excitation de navire, *r,* appliqué lors de la commande du navire,

- obtenir (40) des données de mouvement du navire provenant de capteurs du navire lorsque le navire est sous l'influence du signal d'excitation de navire,
- utiliser (42) les données de mouvement du navire et le signal d'excitation dans un modèle dynamique du navire comportant une perturbation de processus, $v$, et un ensemble de paramètres, $\theta$, comportant au moins un paramètre définissant un modèle de bras de levier de redressement,
- déterminer (44) un ou plusieurs résidus, et
- obtenir (46) le modèle de bras de levier de redressement par minimisation d'une fonction des résidus.

2. Procédé selon la revendication 1, le modèle dynamique pouvant être exprimé comme un modèle dynamique à espace d'états comportant un modèle de mesure, $h$, et une fonction de transition d'états, $f$.

3. Procédé selon la revendication 2, le modèle de mesure, $h$, étant fonction d'au moins un état, du signal d'excitation, de l'ensemble de paramètres et de la perturbation de processus et la fonction de transition d'états, $f$, étant fonction d'au moins un état, du signal d'excitation et de l'ensemble de paramètres.

4. Procédé selon l'une quelconque des revendications précédentes, les résidus étant exprimés comme une différence entre un signal mesuré et une estimation correspondante du signal mesuré dans le modèle dynamique.

5. Procédé selon la revendication 2 ou 3, le modèle dynamique étant linéaire et représenté par un opérateur de transfert, $G_d(q)$, et les résidus étant obtenus en multipliant l'opérateur de transfert, $G_d(q)$, ainsi que la perturbation de processus, $v$, par le signal d'excitation et en passant à l'espérance mathématique.

6. Procédé selon la revendication 2 ou 3, le modèle dynamique étant linéaire et représenté par un opérateur de transfert, où les résidus sont obtenus en utilisant une méthode de variable instrumentale sur l'opérateur de transfert.

7. Procédé selon l'une quelconque des revendications précédentes, l'ensemble de paramètres étant obtenu à partir d'un modèle masse-ressort-amortisseur du navire comprenant un couple de rappel, un terme de perturbation dépendant de l'excitation et un terme de perturbation de processus.

8. Procédé selon la revendication 7, le modèle masse-ressort-amortisseur étant basé sur une équation différentielle liée à un angle de pivotement autour d'un point de pivot du navire.

9. Procédé selon la revendication 7 ou 8, les données de mouvement du navire comportant un signal de vitesse, $y_1$, et un signal d'accélération, $y_2$.

10. Procédé selon la revendication 9, l'accélération du navire, $a_y$, étant éliminée du modèle masse-ressort-amortisseur par résolution d'une équation spécifiant la relation entre le signal d'accélération et l'accélération du navire, $a_y$, et insertion de l'expression de l'accélération du navire dans le modèle masse-ressort-amortisseur.

11. Procédé selon l'une quelconque des revendications précédentes, le signal d'excitation de navire, $r$, étant un signal de gouvernail.

12. Procédé selon l'une quelconque des revendications précédentes, le modèle de bras de levier de redressement étant proportionnel à la hauteur métacentrique, $\overline{GM}_T$.

13. Dispositif de détermination de stabilité de navire destiné à déterminer un modèle du bras de levier de redressement d'un navire (10), le dispositif comportant une unité (22) de détermination de modèle de bras de levier de redressement configurée pour :

- obtenir un signal d'excitation de navire, $r$, appliqué lors de la commande du navire,
- obtenir des données de mouvement du navire provenant de capteurs (20) du navire lorsque le navire est sous l'influence du signal d'excitation de navire,
- utiliser les données de mouvement du navire et le signal d'excitation dans un modèle dynamique du navire comportant une perturbation de processus, $v$, et un ensemble de paramètres, $\theta$, comportant au moins un paramètre définissant le modèle de bras de levier de redressement,
- déterminer un ou plusieurs résidus, et
- obtenir le modèle de bras de levier de redressement par minimisation d'une fonction des résidus.

**14.** Dispositif (22) selon la revendication 13, le modèle dynamique pouvant être exprimé comme un modèle dynamique à espace d'états comportant un modèle de mesure, *h,* et une fonction de transition d'états, *f.*

**15.** Dispositif (22) selon la revendication 14, le modèle de mesure, *h,* étant fonction d'au moins un état, du signal d'excitation, de l'ensemble de paramètres et de la perturbation de processus et la fonction de transition d'états, *f,* étant fonction d'au moins un état, du signal d'excitation et de l'ensemble de paramètres.

**16.** Dispositif (22) selon l'une quelconque des revendications 13 à 15, les résidus étant exprimés comme une différence entre un signal mesuré et une estimation correspondante du signal mesuré dans le modèle dynamique.

**17.** Dispositif (22) selon la revendication 14 ou 15, le modèle dynamique étant linéaire et représenté par un opérateur de transfert, $G_d(q)$, et la perturbation de processus, *v,* et l'unité (22) de détermination de modèle de bras de levier de redressement étant configurée pour obtenir les résidus en multipliant l'opérateur de transfert, $G_d(q)$, ainsi que la perturbation de processus, *v,* par le signal d'excitation et en passant à l'espérance mathématique.

**18.** Dispositif (22) selon la revendication 14 ou 15, le modèle dynamique étant linéaire et représenté par un opérateur de transfert, et l'unité (22) de détermination de modèle de bras de levier de redressement étant configurée pour obtenir les résidus en utilisant une méthode de variable instrumentale sur l'opérateur de transfert.

**19.** Dispositif (22) selon l'une quelconque des revendications 13 à 18, l'ensemble de paramètres étant obtenu à partir d'un modèle masse-ressort-amortisseur du navire comprenant un couple de rappel, un terme de perturbation dépendant de l'excitation et un terme de perturbation de processus.

**20.** Dispositif (20) selon la revendication 19, le modèle masse-ressort-amortisseur étant basé sur une équation différentielle liée à un angle de pivotement autour d'un point de pivot du navire.

**21.** Dispositif (20) selon les revendications 13 à 20, comportant en outre un ordinateur (32) de gestion de capteurs servant à recevoir les données de vitesse du navire.

**22.** Dispositif selon la revendication 21, comportant en outre une unité (20) de mesures inertielles mesurant des données de vitesse du navire.

**23.** Dispositif (20) selon l'une quelconque des revendications 13 à 22, comportant en outre un ordinateur (24) de commande de manœuvre du navire.

**24.** Produit de programme d'ordinateur destiné à déterminer un modèle du bras de levier de redressement d'un navire, ledit produit de programme d'ordinateur étant placé sur un support (56) de données comportant du code (58) de programme d'ordinateur configuré pour amener une unité (22) de détermination de modèle de bras de levier de redressement d'un dispositif de détermination de stabilité de navire, lorsque ledit code de programme d'ordinateur est chargé dans l'unité de détermination de modèle de bras de levier de redressement, à :

- obtenir un signal d'excitation de navire, *r,* appliqué lors de la commande du navire,
- obtenir des données de mouvement du navire provenant de capteurs du navire lorsque le navire est sous l'influence du signal d'excitation de navire,
- utiliser les données de mouvement du navire et le signal d'excitation dans un modèle dynamique du navire comportant une perturbation de processus, *v,* et un ensemble de paramètres, *θ,* comportant au moins un paramètre définissant le modèle de bras de levier de redressement,
- déterminer un ou plusieurs résidus, et
- obtenir le modèle de bras de levier de redressement par minimisation d'une fonction des résidus.

10

18

16

14

20

12

FIG. 1

21

22

B1

14

24

26

28

30

32

34

36

18

20

FIG. 2

58

56

FIG. 7

FIG. 3

OBTAIN SHIP EXCITATION SIGNAL APPLIED IN SHIP CONTROL — 38

OBTAIN SHIP MOTION DATA — 40

USE IN DYNAMIC MODEL — 42

DETERMINE RESIDUALS — 44

OBTAIN RIGHTING ARM MODEL THROUGH MINIMIZING A FUNCTION OF THE RESIDUALS — 46

FIG. 4

FIG. 5

FIG. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2431405 A
- US 3982424 A
- WO 2005101953 A
- WO 2013172408 A

**Non-patent literature cited in the description**

- **R. A. IBRAHIM ; I. M. GRACE.** Modeling of Ship Roll Dynamics and Its Coupling with Heave and Pitch. *Mathematical Problems in Engineering,* 2010, vol. 30 (5